# EUROPÄISCHE PATENTSCHRIFT

(11) **EP 4 185 742 B1**
(45) Veröffentlichungstag und Bekanntmachung des Hinweises auf die Patenterteilung: **23.10.2024**
(21) Anmeldenummer: 22786008.7
(22) Anmeldetag: 16.09.2022
(51) Int. Cl.: C30B 23/00, C30B 29/36

(54) **PVT-VERFAHREN UND APPARATUR ZUM PROZESSSICHEREN HERSTELLEN VON EINKRISTALLEN**
PVT-METHOD AND DEVICE FOR PRODUCING SINGLE CRYSTALS IN A SAFE MANNER WITH REGARD TO THE PROCESS
PROCÉDÉ DE TRANSPORT PHYSIQUE EN PHASE VAPEUR ET APPAREILLAGE PERMETTANT DE RÉALISER DES MONOCRISTAUX DE MANIÈRE FIABLE

(30) Priorität: 16.09.2021 DE 102021123991
(43) Veröffentlichungstag der Anmeldung: 31.05.2023
(73) Patentinhaber: PVA TePla AG, 35435 Wettenberg (DE)
(72) Erfinder: SCHÖLER, Michael, 91077 Dormitz (DE); VOGEL, Lorentz, 35460 Staufenberg (DE); VIEHMANN, Karsten, 35625 Hüttenberg (DE); BAUMECKER, Tomas, 35305 Grünberg (DE)
(74) Vertreter: Rauch, Udo
(86) Internationale Anmeldenummer: PCT/EP2022/075759
(87) Internationale Veröffentlichungsnummer: WO 2023/041703

(56) Entgegenhaltungen:
- JP-A- H04 193 799
- US-A1- 2012 192 790

## Beschreibung

### Gebiet der Erfindung

Die Erfindung bezieht sich auf ein PVT-Verfahren zum prozesssicheren Herstellen von Einkristallen in einer Apparatur, die eine hoch erhitzbare Wachstumszelle, eine Prozesskammer, in der sich die Wachstumszelle befindet, und eine die Prozesskammer umgebende Heizeinrichtung zum Erhitzen der Wachstumszelle aufweist, wobei ein Quellmaterial und ein Keim in die Wachstumszelle eingebracht werden, die Prozesskammer mit einem Prozessgas befüllt und die Wachstumszelle erhitzt wird, so dass das Quellmaterial sublimiert und am Keim resublimiert wird.

### Hintergrund und allgemeine Beschreibung der Erfindung

Im industriellen Umfeld wird das sogenannte Physical Vapor Transport (PVT) Verfahren als Standardmethode zur Herstellung von einkristallinen Siliciumcarbid-Kristallen (SiC-Kristallen) betrachtet. Das Quellmaterial ist in der Regel ein Pulver, das viele unterschiedliche Kristallite enthält. Möglich ist auch der Einsatz von Volumenkristallen. Als alternatives Verfahren ist das High-Temperature Chemical Vapor Deposition (HT-CVD) Verfahren bekannt. Das Kristallwachstum erfolgt beim PVT-Verfahren typischerweise innerhalb der aus Graphit bestehenden Wachstumszelle durch Sublimation eines SiC-Quellmaterials und Kristallisation an einem vorgegebenen SiC-Keim bei Temperaturen von über 2.000 °C. Die Triebkraft für das Kristallwachstum stellt ein Temperaturgradient dar, der der Wachstumszelle durch eine Heizeinrichtung aufgeprägt wird. Gängige Verfahren zur Beheizung von PVT-Apparaturen nutzen Widerstandsheizer oder Induktionsheizungen. Bei der induktiven Beheizung ist die Wachstumszelle (Hot-Zone) der vakuumdichten Prozesskammer aus einem nichtleitenden Material, typischerweise (Quarz-)glas umgeben, in der sich Prozessgase befinden, die u.a. zur Beeinflussung des Kristallwachstums benötigt werden. Die Prozesskammer kann ein- oder doppelwandig sein sowie luft- oder wassergekühlt ausgeführt sein. Als Prozessgase kommen typischerweise Argon, Helium, Stickstoff, Wasserstoff und ggf. weitere Gase zur gezielten Dotierung zum Einsatz. Der Prozessdruck kann sich von Vakuum-Bedingungen bis Atmosphärendruck erstrecken. In gängigen Prozessen zur Herstellung von dotierten SiC-Einkristallen wird kein Wasserstoff oder nur geringe Konzentrationen eingesetzt.

SiC-Einkristalle werden wegen ihrer großen Bandlücke und ihrer hohen Wärmeleitfähigkeit für eine Vielzahl von Anwendungen in der Halbleitertechnik benötigt.

Das zugrundeliegende Verfahren zur Herstellung von SiC-Einkristallen ist daher schon Gegenstand vieler Beschreibungen. Exemplarisch wird auf die US 2011/ 0300323 A1 verwiesen. Demnach wird ein Inertgas als Prozessgas verwendet, was unter sicherheitstechnischen Aspekten unproblematisch ist. Zum Stand der Technik sei auch noch auf die EP 0 811 708 A2, US 2012/0086001 A1, GB 772,691, DE 60 2004 001 802 T2, EP 3 760 765 A: und JP H04 193799 A verwiesen.

Es ist ein gedanklicher Ausgangspunkt und eine der Aufgaben der vorliegenden Erfindung, Prozesse, u.a. zur gezielten Beeinflussung des Dotierstoffeinbaus oder zur Herstellung von undotierten SiC-Einkristallen, erfolgen können, zu ermöglichen. Hinsichtlich dieses Ausgangspunkt wird im Rahmen der vorliegenden Erfindung entwickelt, unter Einsatz eines Reaktivgases, d.h. eines brennbaren und/oder reaktiven (ggf. auch toxischen) Gases, z.B von Wasserstoff als Prozessgas, mit Konzentrationen von über 5% und bis zu 100%, einen Prozessablauf sicher, mit besseren Ergebnissen als im Stand der Technik und dennoch kostengünstig zu gewährleisten.

Dabei lagern sich die Gasmoleküle des Reaktivgases wie insbesondere Wasserstoffatome an die Oberfläche des wachsenden Einkristalls an, werden aber sogleich von den folgenden sublimierten Bestandteilen des Quellmaterials verdrängt. Die Reaktivgasmoleküle, wie z.B. Wasserstoffatome, dienen in diesem Fall kurzzeitig als Platzhalter, so dass ein fehlerarmes, wenn nicht gar fehlerfreies Kristallgitter entstehen kann. Reaktivgasmoleküle können auch Reaktionen mit anderen Prozessgasen, dem Quellmaterial oder sogar dem HotZone-Material eingehen und weitere gasförmige Spezies ausbilden, die in die Prozessgasatmosphäre gelangen und sich zumindest zwischenzeitlich am Kristall anlagern können. Mögliche Reaktivgase wie Silan, Methan, Propan, etc. liefern u.a. die Elemente Silizium und Kohlenstoff, die in den Kristall mit eingebaut werden. Die Zugabe von Reaktivgasen kann insgesamt die Defektdichte (gewünscht und/oder unerwünscht) beeinflussen. Die genaue Beeinflussung hängt jedoch von einer Vielzahl von Parametern und dessen Zusammenspiel ab. Mit einer Reaktivgas-Zugabe soll eine Beeinflussung des Kristallwachstums erfolgen.

Die Aufgabe der vorliegenden Erfindung kann also darin gesehen werden, eine Vorrichtung und ein Verfahren bereitzustellen mit welchen ein verbessertes oder verändertes Kristallwachstum ermöglicht ist.

In einem Teilaspekt bzw. Weiterbildung der Erfindung kann als Aspekt der Aufgabe angesehen werden, eine Vorrichtung und ein Verfahren bereitzustellen, bei welchen ein Reaktivgas einsetzbar ist zur Verbesserung des Kristallwachstums.

In noch einem weiteren Teilaspekt bzw. Weiterbildung der Erfindung kann die Aufgabe gestellt sein, eine Vorrichtung und ein Verfahren bereitzustellen, mittels welchen unter geringem Aufwand bzw. kostengünstig verbesserte Kristalle bereitstellbar sind.

Die Verwendung eines Reaktivgases, umfassend z.B. Wasserstoff oder andere reaktive Elemente, stellt aber ein Gefahrenpotential bei der Durchführung des Verfahrens dar. Ein reaktives Gas kann beispielsweise brennbar bzw. entzündlich und/oder toxisch ausgebildet sein. Im Falle des Beispiels Wasserstoff kann mit dem Sauerstoff der Luft eine Knallgasreaktion stattfinden, weshalb Wasserstoff im Rahmen dieser Beschreibung als Reaktivgas bezeichnet wird. Weitere Beispiele für derzeit in Frage kommende Reaktivgase umfassen neben Wasserstoff auch Kohlenstoff- und Siliziumhaltige Vorstufen oder Kohlenwasserstoffe und deren Derivate (Beispiele: Silan oder auch Methan, Propan, etc.).

Darüber hinaus ist bei heutzutage üblichen Apparaturen die Prozesskammer typischerweise aus Quarzglas gebildet, das von Natur aus spröde ist und zum Brechen neigt. Es ist aber besonders bevorzugt, Quarzglas zu verwenden, weil es die hohen Temperaturen der Wachstumszelle aushalten kann und weil es das elektromagnetische Feld einer Induktionsspule bzw. die Strahlungswärme eines Widerstandsheizers nicht abschirmt. Ebenso kann eine Kombinationen aus Induktions- und Widerstandsheizer vorgesehen sein. Z.B. kann ein Boden- oder Decken-Zusatzheizer als Widerstandsheizer ausgeführt sein, während der Hauptheizer als Induktionsheizung ausgeführt ist. Grundsätzlich stellen sich die Sicherheitsanforderungen aber in ähnlicher Weise auch an andere Baustoffe zur Bereitstellung der Prozesskammer, jedenfalls im Falle des Quarzglases im besonderen Maße.

Wenn aber die Prozesskammer beschädigt bzw. undicht wird, also beispielsweise wenn das Quarzglas bricht, kann sich der Wasserstoff mit dem Sauerstoff der Umgebung vermischen und es entsteht ein Knallgas, das von der Heizeinrichtung (heißen Komponenten der Hot-Zone, typischerweise Graphitteile im Inneren der Prozesskammer) gezündet wird und explodiert. Soweit ein reaktives Gas Verwendung findet, ist daher eine prozesssichere Durchführung des Verfahrens mit den bekannten Armaturen nicht möglich.

Ein in der vorliegenden Beschreibung genanntes Reaktivgas - insbesondere Wasserstoff - ist nicht gleichzusetzen mit bekannten Dotiergasen. Bekannte typische Dotiergase werden nicht in den hier gewünschten Konzentrationen eingesetzt, und/oder sind weder entzündlich noch in anderer Weise reaktiv im Sinne der in dieser Beschreibung verwendeten Bedeutung. Dotiergase werden um den Kristall gespült, die Vorgänge finden also vollständig in der Prozesskammer statt. Beispielsweise kann in diesem Zusammenhang auch die Prozesskammer mit einem Inertgas wie Argon gespült werden, um den PVT-Prozess direkt zu modifizieren. Generell sind Dotiergase dazu vorgesehen, in den Kristall bzw. die Kristallstruktur mit eingebaut zu werden - woher sich auch die Bezeichnung "Dotiergas" ableitet - um physikalische und/oder chemische Eigenschaften des Kristalls zu beeinflussen, beispielsweise die elektrische Leitfähigkeit. Mit anderen Worten formen Moleküle bzw. Bestandteile eines Dotiergases einen späteren integralen Baustoff des Kristalls. Solche Moleküle bzw. Bestandteile eines Dotiergases verbleiben im Kristall und sind dort später nachweisbar.

Im Gegensatz hierzu kann ein Reaktivgas wie Wasserstoff als reaktiver Bestandteil der Gasatmosphäre das Kristallwachstum und den Dotierstoffeinbau beeinflussen, soll aber nicht wie Dotiergas in den Kristall mit eingebaut werden, um die physikalischen und chemischen Eigenschaften des Kristalls zu beeinflussen. Aufgrund des Gefahrenpotentials reaktiver Gase, das heißt insbesondere Zündung, Abbrand, Verpuffung oder auch Vergiftungspotential, wurden reaktive Gase bislang nicht für den Einsatz zur Verbesserung des Kristallwachstums in Betracht gezogen, oder jedenfalls die wie vorstehend beschriebenen Sicherheitsaspekte im Umgang mit einem Reaktivgas in diesem Umfeld nicht ausreichend berücksichtigt. Darüber hinaus ist das einzusetzende Reaktivgas kein Quellmaterial im eigentlichen Sinne. Bei typischen PVT-Prozessen ist das Quellmaterial SiC-Pulver. Bei Varianten des klassischen PVT-Verfahrens wie z.B. HT-CVD kann Wasserstoff als Trägergas eingesetzt sein, das das eigentliche Quellmaterial i.d.R. gasförmige C- bzw. Si-haltige Präkursoren transportiert. Das Gas dient dort also als Trägergas, d.h. als Transportmedium für Präkursoren und für Dotierstoffe. Dotierstoffe können feste, flüssige oder gasförmige Elemente oder Verbindungen sein, die typischerweise Stickstoff, Phosphor, Aluminium, Bor oder Vanadium enthalten.

Im Rahmen dieser Weiterentwicklung und Verbesserung wurde mit der vorliegenden Beschreibung der die Prozesskammer umgebende Sicherheitsbehälter entworfen. Des Weiteren wurde die Bereitstellung einer Schutzatmosphäre, insbesondere mit Inertgas, im Bereich zwischen Prozesskammer und Behälterwandung eruiert. Ein mit dem Sicherheitsbehälter insbesondere angestrebtes Ziel ist die Vermeidung bzw. Unterbindung eines explosionsfähigen Gasgemisches im Falle der Beschädigung, insbesondere des Bruchs, der Prozesskammer.

Um zu einer prozesssicheren Durchführung des Verfahrens zu gelangen, könnte eine Apparatur zur Durchführung des Verfahrens in einer Vakuumzelle angeordnet werden. Eine solche Zelle müsste aber absolut vakuumdicht sein und ist daher vergleichsweise aufwändig herzustellen, weil eine Vielzahl von Durchführungen für die Versorgung der Apparatur mit Strom, Gas und ggf. Kühlfluid benötigt wird, die jede für sich vakuumdicht hergerichtet sein muss.

Vorteilhaft wäre hingegen, ein PVT-Verfahren zum prozesssicheren Herstellen von Einkristallen darzustellen, das in einer mit geringem Aufwand herzustellenden und/oder kostengünstigen Apparatur durchführbar ist.

Das Problem wird gelöst durch die in den unabhängigen Ansprüchen definierte Erfindung. Abhängige Ansprüche geben Weiterbildungen und bevorzugte Ausgestaltungen der Erfindung wieder.

Zur Lösung der Aufgabe sieht die Erfindung vor, dass das Prozessgas zum Teil oder vollständig aus einem reaktiven Gas besteht und dass die Prozesskammer in einem Sicherheitsbehälter angeordnet wird, wobei ein Zwischenraum zwischen einer Behälterwandung des Sicherheitsbehälters und der Prozesskammer mit einer Schutzatmosphäre, beispielsweise einem Inertgas, geflutet wird, um die darin befindliche Luft zu verdrängen, bevor die Sublimation des Quellmaterials eingeleitet wird.

Die Flutung des Sicherheitsbehälters sollte spätestens dann erfolgt sein, wenn die Sublimation des Quellmaterials erfolgt, weil dann hohe Temperaturen vorliegen, die das reaktive Gas zu zünden vermögen. Aus Sicherheitsgründen, sollte die Flutung des Sicherheitsbehälters aber schon vor Einleitung des reaktiven Gases in die Prozesskammer erfolgen.

Sollte es bei dieser Anordnung zu einer Beschädigung - insbesondere einem Bruch - der Prozesskammer kommen, mischt sich das reaktive Gas der Prozesskammer in der Schutzatmosphäre im Sicherheitsbehälter, beispielsweise mit dem Inertgas, zu einem nicht explosiven Gasgemisch, so dass es selbst in einer heißen Umgebung nicht zu einer Explosion kommen kann.

Diese Sicherheitsmaßnahme ist besonders wichtig, wenn das reaktive Gas entzündlich ist oder zu Verpuffungen neigt, wie beispielsweise Wasserstoff.

Der Sicherheitsbehälter ist besonders einfach zu realisieren, wenn er so aufgebaut ist, dass er Gasverluste nach außen insbesondere in geringem Umfang zulässt, also nur näherungsweise gasdicht ist. Dies macht die Konstruktion des Sicherheitsbehälters kostengünstiger, da Anforderungen an eine besonders hohe Hermetizität nicht zu berücksichtigen sind und dennoch keine unerwünschten Reaktionen des Reaktivgases außerhalb der Prozesskammer auftreten können. Beispielsweise kann der Sicherheitsbehälter eine zulässige Leckrate aufweisen, die größer ist als 0 l/min. So kann es aus Kostengründen vorteilhaft und unproblematisch sein, insbesondere aufgrund der Wahl und Geometrie der Konstruktion, eine Leckrate zuzulassen, die im Bereich 0 ≤ Leckrate ≤ 5 l/min liegt, oder auch im Bereich 0 ≤ Leckrate ≤ 30 l/min. Beispielsweise kann die zuzulassende Leckrate größer sein als 2 ml/min, weniger bevorzugt 5 ml/min, noch weniger bevorzugt 10 ml/min, noch weniger bevorzugt 50 ml/min oder auch 100 ml/min. Andererseits ist es nicht sinnvoll, aus ökonomischen Gründen und ggf. solchen der Arbeitsplatzsicherheit, eine zu hohe Leckrate des Sicherheitsbehälters zuzulassen. So kann beispielsweise gewünscht sein die Leckrate zu begrenzen auf weniger als 30 l/min, bevorzugt 10 l/min, weiter bevorzugt 4 l/min, noch bevorzugt 1 l/min, weiter bevorzugt 500 ml/min, und noch weiter bevorzugt 150 ml/min. Es wird anvisiert, Leckraten in einem Bereich von 2 ml/min bis 50ml/min zu erzielen, bevorzugt von 10 ml/min bis 20 ml/min.

Zur Aufrechterhaltung der Schutzatmosphäre kann beispielsweise Inertgas nachgeführt werden, um Gasverluste auszugleichen und um einen Überdruck im Sicherheitsbehälter aufzubauen und/oder aufrechtzuerhalten. Der Überdruck verhindert, dass der Luftsauerstoff von außen in den Sicherheitsbehälter gelangen kann. So kann mittels einer Druckregelanlage ein relativer Überdruck im Sicherheitsbehälter aufrecht erhalten werden, beispielsweise in einem Bereich von 1 mBar über Umgebungsdruck oder mehr, bevorzugt 3 mBar oder mehr, weiter bevorzugt von 5 mBar oder mehr, bis 50 mBar über Umgebungsdruck oder weniger, bevorzugt 30 mBar oder weniger. Aber auch ein vollständig gasdichter Sicherheitsbehälter mit einer Leckrate von 0 ml/min oder einer nicht messbar geringen Leckrate sei grundsätzlich hiervon umfasst, bei welchem ebenfalls ein Überdruck im Sicherheitsbehälter aufrechterhalten bleiben kann.

Um die möglichst vollständige Verdrängung von Luft aus dem Sicherheitsbehälter zu gewährleisten, kann die vorliegende Beschreibung weiterhin vorsehen, dass zum Fluten des Sicherheitsbehälters ein erstes Inertgas in den Sicherheitsbehälter eingelassen wird. Das erste Inertgas kann schwerer als Luft sein, so dass es in den unteren Bereich des Sicherheitsbehälters eingelassen wird, wobei die Luft nach oben verdrängt wird. Hierzu kann beispielsweise ein verschließbarer Auslass am oberen Ende des Sicherheitsbehälters so lange offen bleiben, bis die Luft entwichen ist.

Vorzugsweise umfasst die Schutzatmosphäre ein Inertgas wie insbesondere Argon. Wegen der hohen Dichte von Argon sammelt es sich am Boden des Sicherheitsbehälters und verdrängt die Luft langsam nach oben ohne sich mit ihr zu vermischen. Weitere Beispiele für den Aufbau der Schutzatmosphäre, die derzeit wirtschaftlich vertretbar erhältlich sind, umfassen Xenon, Stickstoff oder Kohlenstoffdioxid. Grundsätzlich kann die Schutzatmosphäre jedes Fluid, ob einzeln oder als Gemisch, umfassen, welches eine Schutzfunktion dahingehend bereitzustellen vermag, das Reaktivgas im Falle einer übermäßigen bzw. unzulässigen Entweichung aus der Prozesskammer zu neutralisieren und/oder negative Effekte wie Verpuffungen zu unterbinden. Die Schutzatmosphäre kann beispielsweise auch unter Normalbedingungen der Standardatmosphäre im flüssigen oder festen Zustand vorliegen.

Wenn die Luft durch das erste Inertgas verdrängt worden ist, kann es durch ein anderes, beispielsweise ein kostengünstigeres, Inertgas ersetzt werden. Die Erfindung sieht daher weiterhin vor, dass nach einem ein- oder mehrmaligen Fluten des Sicherheitsbehälters mit dem ersten Inertgas, dieses durch das zweite Inertgas, insbesondere Stickstoff, ersetzt wird.

Um sicherzustellen, dass bei einem Bruch der Prozesskammer nicht weiter das reaktive Gas in die Apparatur geleitet wird, ist vorgesehen, dass der Sicherheitsbehälter einen Gassensor aufweist, der in der Lage ist, das Vorhandensein reaktiven Gases im Sicherheitsbehälter zu detektieren. Ferner kann vorgesehen sein, dass die Prozessgaszufuhr zur Prozesskammer unterbrochen wird, wenn der Gassensor das reaktive Gas im Sicherheitsbehälter detektiert.

In einer Weiterbildung kann über einen weiteren Drucksensor bzw. Druckschalter, der den Druck innerhalb der Prozesskammer überwacht, die Gaszufuhr unterbrochen werden, wenn im Falle eines Schadens, wie eines Bruchs des Quarzglases, ein geringerer Druck detektiert wird. Beispielsweise kann für die Überwachung ein Unterschreiten des Absolutdruckes auf p ≤ 980 mbarAbs , bevorzugt auf p ≤ 950 mbarAbs, weiter bevorzugt auf p ≤ 920 mbarAbs detektiert werden. Die Unterbrechung der Reaktivgaszufuhr kann damit auch unabhängig von der Detektion von Reaktivgas, wie beispielsweise Wasserstoff, im Zwischenraum zwischen Prozesskammer und Kühlmantel erfolgen.

Eine Öffnung der Prozesskammer, beispielsweise im Falle des Bruchs des Quarzglases, kann beispielsweise durch eins der folgenden Kriterien detektiert oder angezeigt werden. Es kann eine Detektion des Reaktivgases/Wasserstoffs durch einen Gassensor im Sicherheitsbehälter erfolgen. Alternativ oder kumulativ kann der Überdruck im Sicherheitsbehälter festgestellt werden und bei Verschwinden des Überdrucks auf eine Prozessstörung geschlossen werden (z.B. p<= ca. 2 mbarÜ gegenüber Atmosphäre).

Des Weiteren kann alternativ oder kumulativ der Druck in der Prozesskammer gemessen werden, und solange dieser Druck ≤ 950 mbarAbs (oder 920 oder 980) beibehalten wird, wird keine Prozessstörung detektiert, wohingegen ein Überschreiten der Druckschwelle eine Prozessstörung anzeigen kann. Auch kann alternativ oder kumulativ ein plötzlicher Druckschlag/Druckanstieg in der Prozesskammer (Druckanstiegsrate größer als maximal mögliche Druckanstiegsrate durch einzuleitenden Gase) festgestellt werden und eine Prozessstörung - wie einen Quarzglasbruch - anzeigen. Die vorgenannten Kriterien sind in vorteilhafter Weise voneinander unabhängig und können einzeln oder in Verbindung miteinander herangezogen werden, ein Abschalten der Prozessgas- bzw. Wasserstoffzufuhr zu erwirken.

Der Sicherheitsbehälter kann in vorteilhafter Weise eine Kühlfunktion bereitstellen. Die Kühlfunktion kann beispielsweise so ausgebildet sein, dass um oder durch den Sicherheitsbehälter ein Kühlmedium zirkuliert, wie insbesondere Wasser. Beispielsweise kann der Sicherheitsbehälter hierfür jedenfalls eine Kühlmediumsleitung aufweisen, durch die das Kühlmedium fließt. Die jedenfalls eine Kühlmediumsleitung kann an der Behälterwandung des Sicherheitsbehälters befestigt sein oder jedenfalls wärmeleitend damit verbunden sein, ggf. unter Zuhilfenahme einer Wärmeleitpaste. Beispielsweise ist die Kühlmediumsleitung an der Behälterwandung aufgelötet. Beispielsweise umfasst die Kühlmediumsleitung Kupfer, welches einfach zu verarbeiten und/oder besonders wärmeleitfähig ausgebildet ist.

Der Sicherheitsbehälter kann derart ausgerüstet sein, eine Temperierung der Prozessbedingungen bereitzustellen. Beispielsweise kann mittels des so gestalteten Sicherheitsbehälters stets konstante Temperaturen - oder ein ähnlicher Temperaturbereich - eingehalten werden, unabhängig von den unter Umständen stark schwankenden Umgebungsbedingungen. Beispielsweise kann die Umgebung eine Tagestemperaturverlaufskurve oder auch jahreszeitliche Temperaturschwankungen beinhalten, oder auch von in der Nähe stattfindenden ggf. thermischen Prozessen beeinflusst werden, wobei der vorteilhaft gestaltete Sicherheitsbehälter diese Umgebungsbedingungen vom Prozess abzuhalten vermag. Alternativ oder kumulativ kann die Kühlfunktion auch in Ansprechen auf die Prozessparameter, also insbesondere der Temperatur in der Prozesskammer, beeinflusst werden, um eine Temperierung des Züchtungsprozesses zu erwirken. So kann beispielsweise der Kühlmediumsdurchsatz durch die zumindest eine Kühlmediumsleitung in Ansprechen auf die Umgebungsbedingungen und/oder die Prozessparameter verändert werden, um den Wärmeabtransport zu verändern. Bei wärmerer Umgebung und/oder Prozesstemperatur kann beispielsweise mehr Kühlmedium umgesetzt werden, und/oder ein kälteres Kühlmedium eingesetzt werden, und/oder ein alternatives Kühlmedium eingefüllt werden.

Die Kühlmediumsleitung kann außenseits der Behälterwandung angeordnet sein, bevorzugt mit der Behälterwandung thermisch leitend verbunden oder jedenfalls benachbart zur Behälterwandung angeordnet. Die Kühlmediumsleitung kann dann die Behälterwandung kühlen und dafür sorgen, dass die Wärmemenge nicht in die unmittelbare Umgebung der Apparatur abstrahlt, sondern von der Temperierungseinrichtung fortgeführt wird. Die außenseitige Anordnung der Kühlmediumsleitung hat den Vorteil, dass weniger abzudichtende Durchführungen in die Schutzatmosphäre bzw. die Innenseite des Schutzbehälters vorzusehen sind, da das Kühlfluid nicht in den Innenraum vordringt. Beispielsweise kann die Behälterwandung doppelwandig ausgeführt sein, also eine Innenwand und eine Außenwand aufweisen, wobei die Kühlmediumsleitung zwischen Innenwand und Außenwand der Behälterwandung angeordnet sein kann. Dann ist die Kühlmediumsleitung nebst der Befestigungen für die Kühlmediumsleitung blickdicht verborgen und vor mechanischer Beschädigung geschützt. Da die Temperierungseinrichtung einen wesentlichen Teil der Wärmeleistung aus der Prozesskammer abzuführen vermag, unterliegt die Außenwand der Behälterwandung keine oder wenigen Einschränkungen hinsichtlich Materialwahl oder Berührschutz, da sie nicht heiß wird.

Die Erfindung bezieht sich weiterhin auch auf eine Apparatur zum prozesssicheren Herstellen von Einkristallen nach dem PVT-Verfahren, die zur Aufnahme eines Quellmaterials und eines Keims eine hoch erhitzbare Wachstumszelle, eine Prozesskammer, in der sich die Wachstumszelle befindet und die zu ihrer Befüllung mit einem Prozessgas einen Anschluss an eine Prozessgasquelle hat, und eine Heizeinrichtung zum Erhitzen der Wachstumszelle aufweist.

Um einen prozesssicheren Betrieb mit einem reaktiven Gas als Prozessgas zu gewährleisten, sieht die Erfindung vor, dass die Apparatur einen eine Behälterwandung aufweisenden Sicherheitsbehälter aufweist, in dem die Prozesskammer angeordnet ist, wobei der Sicherheitsbehälter einen Anschluss an eine Inertgasquelle hat, um vor Durchführung des PVT-Verfahrens einen Zwischenraum zwischen der Behälterwandung des Sicherheitsbehälters und der Prozesskammer mit einem Inertgas fluten zu können.

Der Sicherheitsbehälter kann so aufgebaut sein, dass er Gasverluste nach außen zulässt. Er kann einen Drucksensor aufweisen, wobei der Drucksensor mit einer Steuereinrichtung signalverbunden ist und die Steuereinrichtung so ausgelegt ist, dass auf Basis der Drucksensorsignale ein Überdruck im Sicherheitsbehälter (gegenüber Umgebung bzw. Atmosphäre) eingestellt wird.

Der Drucksensor kann auch Druckschalter umfassen oder aus einem Druckschalter gebildet sein. Beispielsweise kann der Drucksensor durch einen Differenzdruckschalter gebildet sein, der die Druckdifferenz zwischen Inertisierung im Sicherheitsbehälter und Atmosphäre bzw. Umgebung misst. Ggf. kann der Drucksensor dann eine Schaltung auslösen bei Über- oder Unterschreiten einer einstellbaren Druckdifferenz, insbesondere als Sicherheitsschaltung bzw. Absperrung.

Bezogen auf die intendierte Aufstellung der Apparatur befinden sich ein Inertgasanschluss im unteren Bereich des Sicherheitsbehälters und ein verschließbarer Auslass in dessen oberen Bereich. Dadurch wird die Luft im Sicherheitsbehälter von dem im unteren Bereich einströmenden Inertgas vollständig nach oben zum Auslas verdrängt, wo diese den Sicherheitsbehälter verlässt.

Der Sicherheitsbehälter weist vorzugsweise zwei Inertgasanschlüsse für zwei unterschiedliche Inertgase auf. Nachdem das erste Inertgas die Luft aus dem Sicherheitsbehälter verdrängt hat, kann mittels des zweiten Inertgasanschlusses ein kostengünstigeres Fluid, wie zum Beispiel Stickstoff, ein zweites Fluid eingefüllt werden und somit das erste Inertgas ersetzt werden.

Der Sicherheitsbehälter weist vorzugsweise einen Gassensor auf, der auf ein reaktives Gas anspricht. Auf diese Weise kann festgestellt werden, dass reaktives Gas (z. B. Wasserstoff) in den Sicherheitsbehälter eingedrungen ist, beispielsweise im Falle eines Bruchs der Prozesskammer.

Wie schon oben ausgeführt, kann mit der Apparatur insbesondere ein SiC-Einkristall nach dem PVT-Verfahren hergestellt werden. Dazu ist die Wachstumszelle mit einem Siliciumcarbid als Quellmaterial bestückt und die Prozesskammer neben anderen Prozessgasen (z. B. Argon) mit Wasserstoff als reaktives Gas geflutet.

### Kurzbeschreibung der Figuren

Es zeigt:
- Fig. 1: Querschnittsdarstellung einer erfindungsgemäßen Apparatur,
- Fig. 2: perspektivische und vereinfachte Darstellung eines teilmontierten Sicherheitsbehälters,
- Fig. 3: perspektivische Schnittansicht einer Ausführungsform einer Apparatur,
- Fig. 4: Detail eines Anschlusses der Temperierungseinrichtung des Sicherheitsbehälters,
- Fig. 5: Segment der Behälterwandung des Sicherheitsbehälters mit Teil der Temperierungseinrichtung,
- Fig. 6: Aufbau eines beispielhaften Segments einer Behälterwandung mit Temperierungseinrichtung,
- Fig. 7: perspektivische Ansicht einer Ausführungsform eines Sicherheitsbehälters 8.

### Detaillierte Beschreibung der Erfindung

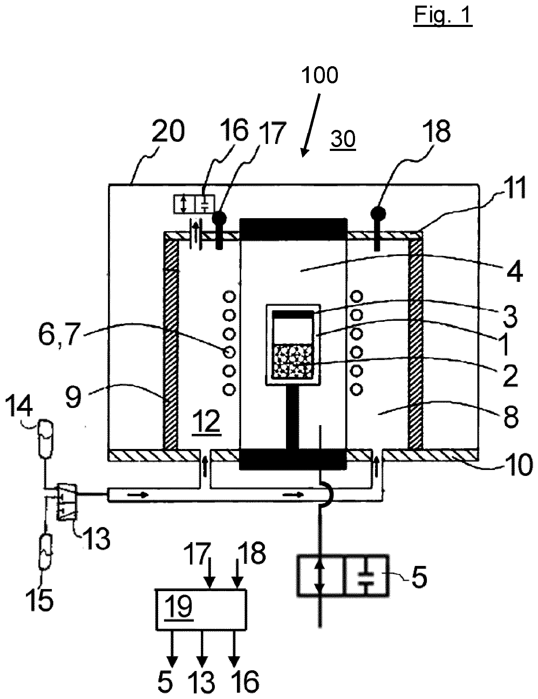

Im Folgenden wird die Erfindung anhand von Ausführungsbeispielen und unter Bezugnahme auf die Figuren näher dargestellt, wobei gleiche und ähnliche Elemente teilweise mit gleichen Bezugszeichen versehen sind und die Merkmale der verschiedenen Ausführungsbeispiele miteinander kombiniert werden können. Die Figur 1 zeigt eine Querschnittsdarstellung einer erfindungsgemäßen Apparatur.

Im Zentrum der Apparatur befindet sich auf einem Ständer stehend eine aus einem Hohlzylinder bestehende Wachstumszelle 1 mit einem Boden und einem Deckel, die die beiden Enden des Hohlzylinders verschließen. Die Wachstumszelle 1 besteht aus einem porösen Graphit. Auf dem Boden wird ein Quellmaterial 2 geschichtet. An der Unterseite des Deckels befindet sich ein Keim 3.

Die Wachstumszelle 1 ist in einer Prozesskammer 4 angeordnet, die aus einem an beiden Enden von einem Boden bzw. einer Decke geschlossenen Hohlzylinder besteht. Die zylindrische Wandung der Prozesskammer 4 besteht aus einem hitzebeständigen Quarzglas und kann über einen Prozessgasanschluss mit einem Einlassventil 5 mit einem Prozessgas befüllt werden. Da der Graphit der Wachstumszelle 1 porös ist, gelangt das Prozessgas von der Prozesskammer 4 auch in die Wachstumszelle 1.

Eine Heizeinrichtung 6 besteht aus einer Induktionsspule 7, die die Prozesskammer 4 auf Höhe der Wachstumszelle umgibt. Wenn diese von einem elektrischen Strom durchflossen wird, erzeugt sie ein elektromagnetisches Feld, das in dem Graphit der Wachstumszelle 1 einen elektrischen Strom induziert, der die Wachstumszelle 1 auf über 2.000 °C bis zu 2.400 °C erhitzt.

Die hohen Temperaturen und die benötigte Durchlässigkeit für das elektromagnetische Feld der Induktionsspule 7 machen es notwendig, zumindest die zylindrische Wandung der Prozesskammer 4 aus einem hierfür geeigneten temperaturbeständigen Material herzustellen. Üblicherweise wird die zylindrische Wandung der Prozesskammer 4 aus Quarzglas hergestellt, welches sich als besonders geeignet erwiesen hat und günstig in der Herstellung ist.

Zur Herstellung eines SiC-Einkristalls wird Siliciumcarbid in die Wachstumszelle 1 gegeben und die Prozesskammer 4 mit einem Prozessgas geflutet, das bis zu 100% aus Wasserstoff besteht. Wird nun die Wachstumszelle 1 mittels der Induktionsspule 7 erhitzt, sublimiert das Siliciumcarbid und lagert sich Lage für Lage an dem Keim 3 an, so dass ein SiC-Einkristall heranwächst. Der Wasserstoff sorgt dafür, dass dabei keine Kristalldefekte im Kristall bilden oder sich an der jeweiligen Wachstumsstelle Fremdatome einlagern könnten. Eine Einlagerung von unerwünschten Fremdatomen führt regelmäßig zu einer Veränderung der elektrischen Leitfähigkeit, die ggf. auch lokal auftreten kann und als Störung bzw. Qualitätsminderung nachteilig sein kann. Auch kann eine Beeinflussung der Prozessgaszusammensetzung durch Reaktionen mit anderen Prozessgasen oder der HotZone (Graphitkomponenten) durch den Einsatz des Reaktivgases erwirkt werden. Die veränderte Prozessgaszusammensetzung kann wiederum Einfluss auf die Kristallinität, Struktur, Kristalldefekte und Dotierung des SiC-Kristalles haben.

Beispielsweise konnte gezeigt werden, dass ab einem Wasserstoffanteil von 5% oder mehr im Prozessgas vorteilhafte Effekte erzielt werden, wobei in derart geringen Konzentrationen von unter 5% Wasserstoff im Prozessgas typischerweise keine Schutzmaßnahmen beispielsweise zum Explosionsschutz notwendig sind. Besonders vorteilhafte Ergebnisse konnten im Bereich zwischen 5% Wasserstoffanteil bis etwa 40% Wasserstoffanteil erhalten werden, wobei im Bereich von 15% Wasserstoffanteil am Prozessgas (insbesondere ±5%) ein erhöhter Reinheitsgrad des Kristalls erhalten werden konnte. Grundsätzlich ist aber auch bei geringen Konzentrationen der Einsatz eines erfindungsgemäßen Sicherheitsbehälters vorteilhaft.

Die Verwendung eines reaktiven Gases wie Wasserstoff ist aber, wie einleitend beschrieben, deshalb problematisch, da bei einem potentiellen Bruch der Wandung der Prozesskammer 4 das reaktive Gas sich - ohne den erfindungsgemäßen Sicherheitsbehälter - mit der Umgebungsluft mischt, so dass beispielsweise ein zündfähiges Gasgemisch entstehen kann, das sich an den heißen Teilen der Apparatur sogleich entzünden würde.

Die Prozesskammer 4 des hier gezeigten Ausführungsbeispiels ist daher von einem Sicherheitsbehälter 8 umgeben, der eine die zylindrische Wandung der Prozesskammer 4 umgebende zylindrische Behälterwandung 9 umfasst, die auf einem Boden 10 steht und oben von einer Decke 11 verschlossen ist. Boden 10 und Decke 11 des Sicherheitsbehälters 8 schließen an den Boden und die Decke der Prozesskammer 4 an.

Der Sicherheitsbehälter 8 kann dabei gleichzeitig Bestandteil des Kühlkonzeptes der Apparatur sein. Mit anderen Worten kann der Sicherheitsbehälter 8 in das Kühlkonzept der Apparatur integriert sein. Dazu kann die zylindrische Behälterwandung 9 mit Kühlkanälen versehen sein, die an ein Kühlsystem angeschlossen sind. Das Kühlkonzept kann also vorsehen, dass der Sicherheitsbehälter 8 eine Kühlfunktion für die Apparatur bereitstellt. Beispielsweise kann durch den Sicherheitsbehälter 8 ein Kühlmedium zirkulieren, wie insbesondere Wasser. Andererseits kann vorgesehen sein, dass die Sicherheitsatmosphäre im Sicherheitsbehälter 8 die Kühlfunktion bereitstellt. Beispielsweise kann hierfür die Sicherheitsatmosphäre umgewälzt werden, um Wärmeleistung abzuführen. Insgesamt kann der Sicherheitsbehälter derart ausgerüstet sein, dass der Sicherheitsbehälter mit seiner Kühlfunktion zur Temperierung der Prozessbedingungen herangezogen werden kann, so dass stets konstante Temperaturen - oder ein ähnlicher Temperaturbereich - eingehalten werden kann, unabhängig von den unter Umständen stark schwankenden Umgebungsbedingungen. Beispielsweise kann die Umgebung eine Tagestemperaturverlaufskurve oder auch jahreszeitliche Temperaturschwankungen beinhalten, oder auch von in der Nähe stattfindenden ggf. thermischen Prozessen beeinflusst werden.

Schließlich kann der Sicherheitsbehälter 8 so aufgebaut sein, dass er metallisch leitfähig ausgerüstet ist. Der metallisch leitfähige Sicherheitsbehälter 8 kann in der Art eines Faraday'schen Käfigs eine Abschirmung für den im Inneren ablaufenden Prozess bereitstellen, so dass beispielsweise elektromagnetische Wechselfelder in der Behälterwandung 9 des Sicherheitsbehälters 8 einen definierten Endpunkt erhalten, und nicht asymptotisch auslaufen, potentiell bis ins Unendliche. Dies kann vorteilhaft sein, wenn mehrere Apparate nebeneinander aufgebaut werden sollen, wobei sich entsprechende Wechselfelder gegenseitig beeinflussen und die Prozessbedingungen gegenseitig stören können. Mit anderen Worten kann der metallisch leitfähig ausgerüstete Sicherheitsbehälter 8 gleichmäßige Prozessbedingungen auch unter der Bedingung gewährleisten, dass mehrere ggf. auch verschiedenartige Apparate nah beieinander aufstellbar sind, ohne dass sich die Prozesse gegenseitig stören.

Insgesamt zeigt sich, dass der Sicherheitsbehälter 8 in synergistischer Weise gleich mehrere Aufgaben zu lösen vermag. Nicht nur, dass er die genannte Schutzatmosphäre bereitzustellen vermag, die die Anwendung eines Reaktivgases in der Prozesskammer ermöglicht. Darüber hinaus vermag der Sicherheitsbehälter 8 die Prozesskammer von verschiedenen Umgebungsbedingungen wie Temperaturschwankungen oder schwankende elektrische und/oder magnetische Felder abzuschirmen und somit für den in der Prozesskammer ablaufenden Prozess gleichmäßige Prozessbedingungen zu gewährleisten.

Im Boden des Sicherheitsbehälters 8 befindet sich eine Ringleitung mit einem oder mehreren Anschlüssen an einem ringförmigen Zwischenraum 12 zwischen der Behälterwandung 9 des Sicherheitsbehälters 8 und der aus einem Quarzglas bestehenden zylindrischen Wandung der Prozesskammer 4. Die Ringleitung ist über ein Wechselventil 13 an eine Argonquelle 14 und an eine Stickstoffquelle 15 angeschlossen.

In der Decke 11 des Sicherheitsbehälters 8 befindet sich ein verschließbares Auslassventil 16. Außerdem ist dort ein Gassensor 17 (insbesondere als Wasserstoffsensor) und ein Drucksensor 18 vorgesehen. Über die gesamte Apparatur kann noch eine Haube 20 aus einem bruchfesten Kunststoff oder einem Blech gestülpt sein, die auf dem Boden des Sicherheitsbehälters 8 aufsitzt.

Des Weiteren ist eine Steuereinrichtung 19 vorgesehen, die mit beiden Sensoren 17, 18 signalverbunden ist und über Steuerleitungen das Wechselventil 13, das Auslassventil 16 und das Einlassventil 5 zur Wasserstoffzufuhr steuert.

Die Steuereinrichtung 19 erlaubt die Durchführung der folgenden Verfahren:
Füllen des Sicherheitsbehälters 8 mit einem Inertgas bevor die Prozesskammer 4 mit Wasserstoff befüllt wird:
(1) Das Auslassventil 16 wird geöffnet.
(2) Das Wechselventil 13 wird so geschaltet, dass Argongas aus der Argonquelle 14 von unten langsam in den Zwischenraum 12 einströmt, so dass sich der Zwischenraum 12 von unten mit dem Argongas füllt, wobei die vorhandene Luft durch das offene Auslassventil 16 (oder Überdruckventil oder dgl.) verdrängt wird.
(3) Schließen des Auslassventils 16 und des Wechselventils 13.
(4) Einhalten einer Füllpause, damit sich noch vorhandene Luftreste vom Argongas nach oben absetzen können.
(5) Ggf. einfache oder mehrfache Wiederholung der Schritte (1) bis (3).
(6) Öffnen des Auslassventils 16.
(7) Schalten des Wechselventils 13, so dass Stickstoffgas von unten langsam in den Zwischenraum 12 einströmt, wobei sich der Zwischenraum 12 von unten mit dem Stickstoffgas aus der Stickstoffquelle 15 füllt und das vorhandene Argongas durch das offene Auslassventil 16 verdrängt wird.
(8) Schließen des Auslassventils 16.
(9) Einstellung und Einhaltung eines Überdrucks im Zwischenraum 12 durch gesteuertes Öffnen des Wechselventils 13, so dass trotz vorhandener und akzeptierter Undichtigkeiten des Sicherheitsbehälters keine Luft in den Zwischenraum 12 einströmen kann.

Ein ausreichender Überdruck liegt bei ca. 2 mbar über Umgebung.

Durchgeführt werden müssen jedenfalls die Schritte (1) bis (3) und (9). Die Schritte (4) bzw. (6) bis (8) sind optional.

Um überprüfen zu können, ob der Zwischenraum 12 im ausreichenden Maße sauerstofffrei ist, kann zusätzlich ein Sauerstoffsensor vorgesehen werden.

Verhalten im Fall eines Bruches der Glaswand im Betrieb:
(1) Ständige Überwachung des Gassensors 17 und
(2) Verschließen der Wasserstoffzufuhr, wenn der Gassensor 17 Wasserstoff im Zwischenraum 12 detektiert.

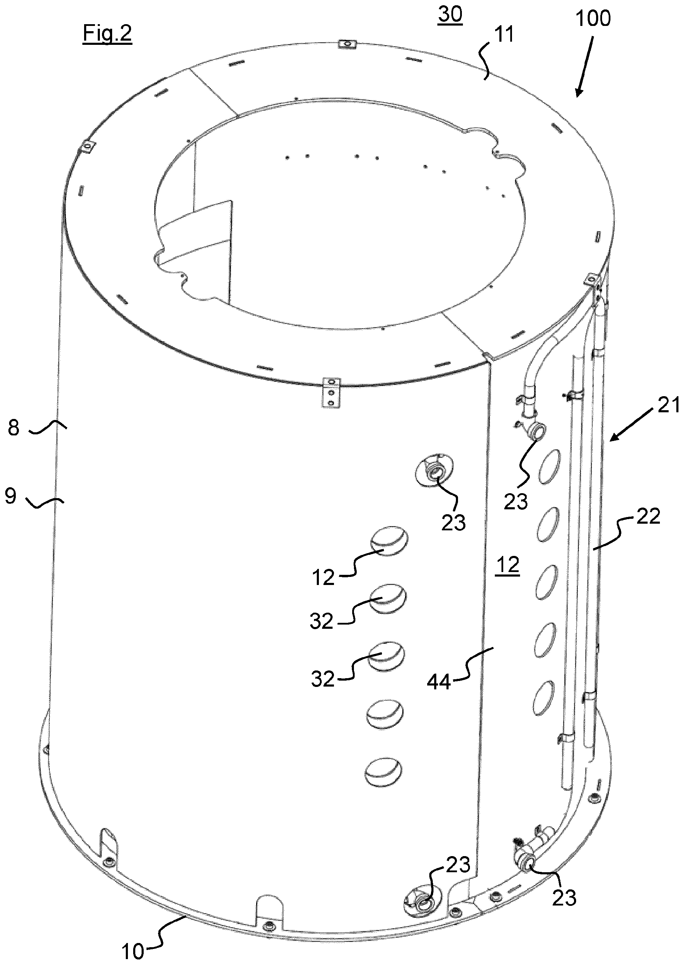

Bezug nehmend auf die Figur 2 ist eine perspektivische Darstellung einer vereinfachten Ausführungsform eines teilmontierten Sicherheitsbehälters 8 gezeigt, wobei aus Gründen der Übersichtlichkeit Anbauteile sowie auch die Prozesskammer 4 nicht dargestellt sind. Ferner sei der Vollständigkeit halber darauf hingewiesen, dass die mit Figur 2 gezeigte Ausführungsform keine Details zur Abdichtung des Innenbereichs 12 aufweist, so dass die mit dieser Ausführungsform erzielbaren Leckraten vergleichsweise hoch ausfallen. Verbessert abgedichtete Sicherheitsbehälter 8 werden mit Ausführungen der weiteren Figuren vorgestellt.

In Fig. 2 ist eine Temperierungseinrichtung 21, jedenfalls teilweise, im Sicherheitsbehälter 8 angeordnet, wobei ein Fluid durch Anschlussstücke 23 in eine Kühlmittelleitung 22 eingespeist werden kann. Die Kühlmittelleitung 22 kann mit der Innenwand 44 des Sicherheitsbehälters 8 verbunden sein, beispielsweise dort angeklebt, gelötet, geschweißt oder angeschraubt. Von der Prozesskammer 4 aus gelangt Wärmeleistung überwiegend als Strahlungswärme an die Innenwand 44, von wo aus die Wärmeleistung effizient mittels der Temperierungseinrichtung 21 abgeführt werden kann. Beispielsweise kann als Kühlmittel flüssiges Wasser eingesetzt werden. Die mit der Temperierungseinrichtung 21 abführbare Wärmemenge kann bevorzugt einstellbar sein. Beispielsweise kann über die Temperaturvorgabe für das Kühlmittel und/oder Durchlaufmenge oder -geschwindigkeit die abführbare Wärmemenge beeinflusst werden, also eine Temperaturregelung bereitgestellt werden. Dann kann in Ansprechen auf Sensorsignale messend die Umgebungstemperatur und/oder die Prozesstemperatur mit der Temperaturregelung eine Temperierung der Prozesskammer 4 erreicht werden, so dass in der Prozesskammer 4 während des Prozessablaufs eine im Wesentlichen konstante Temperatur vorliegt.

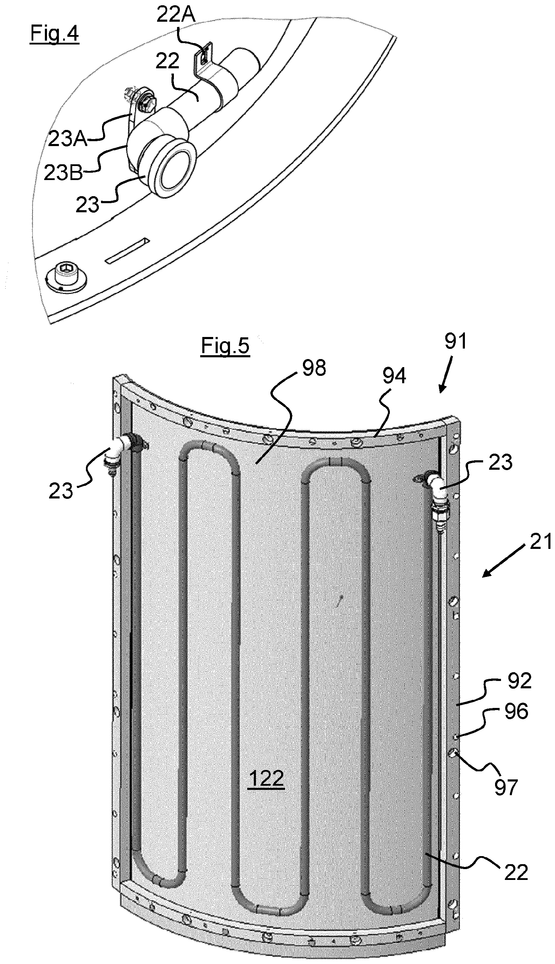

Der Sicherheitsbehälter 8 weist Schaugläser 32 auf, die den Innenbereich 12 überbrücken und beispielsweise zwecks Prozessüberwachung eine Einsicht auf die Prozesskammer 4 ermöglichen. Um die direkte Wärmeausstrahlung klein zu halten sind die Schaugläser 32 relativ klein ausgeführt. Ferner ist mit Fig. 4 ein Detail der Kältemittelleitung 22 mit Leitungsbefestigung 22A, Anschlussstück 23, Übergangsstück 23B und Anschlussstückbefestigung 23A ersichtlich.

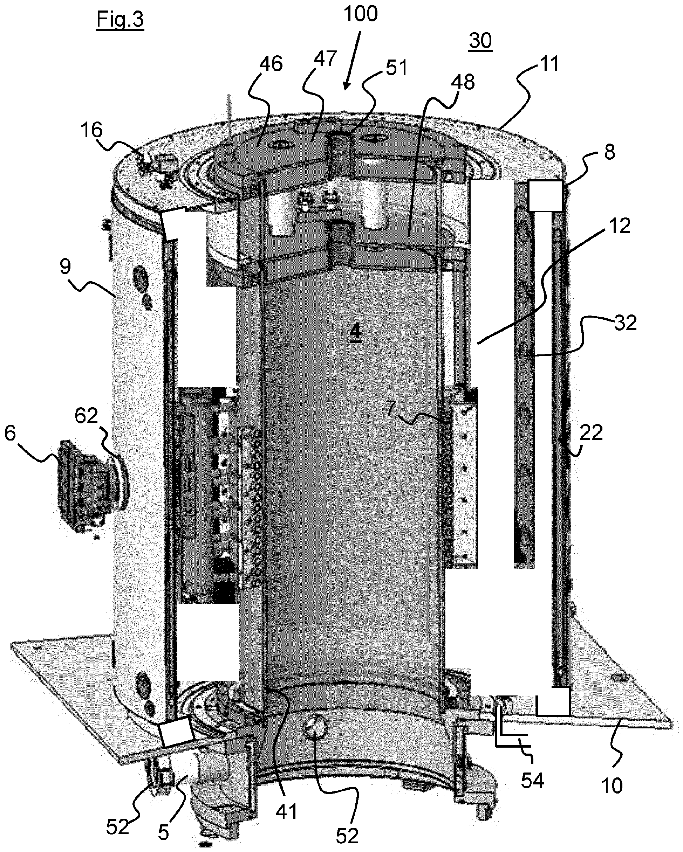

Fig. 3 zeigt eine Schnittdarstellung einer Ausführungsform einer Apparatur 100. Eine Prozesskammer 4 wird von einer Induktionsspule 7 teilweise umgeben, welche von einer Heizeinrichtung 6 mit elektrischer Leistung versorgt wird. Die Heizeinrichtung 6 ist teilweise innerhalb und außerhalb des Sicherheitsbehälters 8 angeordnet, wobei zum Beispiel die Leistungselektronik außerhalb angeordnet sein kann, so dass eine abgedichtete Durchführung 62 zur Reduzierung von Gasleckagen vorgesehen ist. Die Induktionsspule 7 mit Teilen der Elektronik ist im Innenraum 12, also in dem von der Sicherheitsatmosphäre einnehmbaren Raum.

Das Schutzgas kann durch die Schutzgaszuführung 54 an der Unterseite des Innenraums 12 (ggf. mehrere Schutzgaszuführungen 54 vorgesehen) zugeführt werden. An der Oberseite 11 ist das Auslassventil 16 angeordnet, mittels welchem beispielsweise die zunächst im Schutzbehälter 8 angeordnete Außenluft (enthaltend Sauerstoff) aus dem Schutzbehälter 8 herausgelassen werden kann, beispielsweise indem ein Schutzgas eingelassen wird, welches schwerer als Luft ist. Anschließend kann, wenn am Auslassventil 16 eine Anschlussleitung angeschlossen ist (nicht dargestellt), auch eine Zirkulation des Schutzgases bereitgestellt werden, beispielsweise um Wärmemenge aus dem Schutzbehälter 8 abzuführen, oder um einen regelmäßigen Austausch des Schutzgases zu gewährleisten.

Die Kühlmittelleitung 22 der Temperierungseinrichtung 21 ist in dem hier gezeigten Fall in der Behälterwandung 9 angeordnet, welche doppelwandig ausgeführt ist. Bei dem mit Fig. 3 gezeigten Querschnitt des Sicherheitsbehälters 8 mit Prozesskammer 4 erstreckt sich der Innenraum 12 des Sicherheitsbehälters 8 zur Aufnahme der Schutzatmosphäre von der Kammerwandung 41 und beispielsweise rund um die Prozesskammer 4 herum bis zur Behälterwandung 9, wobei der Innenraum 12 gegen die Behälterwandung 9 abgedichtet ausgeführt ist, um die Gasleckrate aus dem Innenraum 12 in die Umgebung 30 gering zu halten.

Ferner zeigt die mit Fig. 3 gezeigte Ausführungsform eine Besonderheit dahingehend, dass die Prozesskammer 4 mit einem Adapter 46 ausgerüstet ist. Der Adapter 46 weist in der gezeigten Ausführungsform zwei alternative obere Abdeckungen 47, 48 auf, so dass je nach gewünschter Prozesshöhe die obere Abdeckung 47 oder die weiter innen liegende obere Abdeckung 48 eingesetzt werden kann. Die Abdeckungen 47, 48 sind somit ggf. alternativ zueinander einsetzbar.

Bezug nehmend auf Fig. 5 ist ein erstes Segment 91 der Behälterwandung 9 eines segmentierten Sicherheitsbehälters 8 mit Temperierungseinrichtung 21 gezeigt, wobei die Kühlmittelleitung 22 in einem Zwischenbereich 122 in der Behälterwandung 9 angeordnet ist. Die Behälterwandung 9 umfasst in dem hier gezeigten Fall eine Innenwand 98, Rahmenteile 92, 94 und die Kühlmittelleitung 22 der Temperierungseinrichtung 21, welche in einem Zwischenbereich 122 angeordnet ist. Auf dem ersten Segment 91 sind Rahmenteile 92, 94 mit Befestigungsmitteln 97 befestigt. Weitere Befestigungsmittel 96 (z.B. Schraublöcher) sind in regelmäßigen Abständen auf den Rahmenteilen 92, 94 angeordnet, so dass der Zwischenbereich 122 davon eingefasst wird.

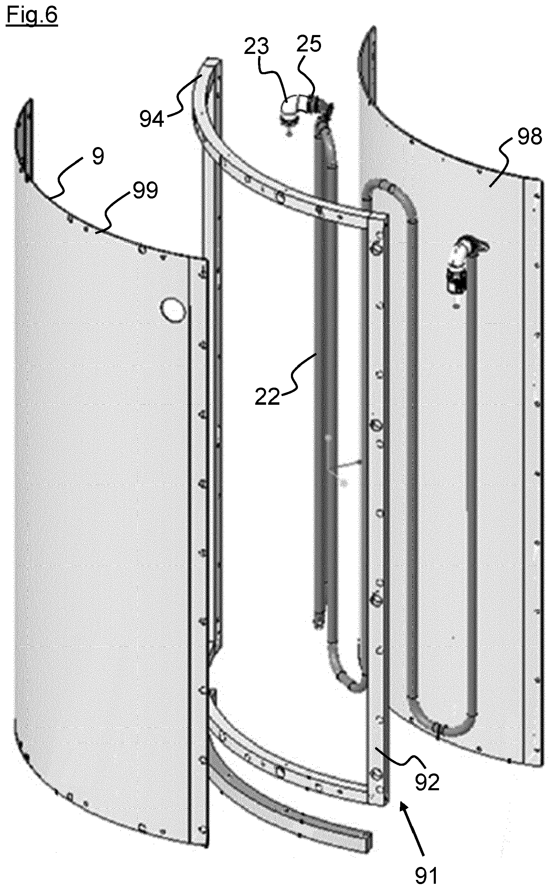

Bezug nehmend auf Fig. 6 wird eine weitere Ausführungsform des ersten Segments 91 mit SandwichAufbau weiter verdeutlicht. An der Innenwand 98 ist die Kühlmittelleitung 22 der Temperierungseinrichtung 21 angeordnet und mittels Anschlüssen 23 nach außen anschließbar. Ein Rahmen 92, 94 umgibt oder begrenzt das Segment 91 umlaufend, wobei eine Außenblende 99 auf den Rahmen 92, 94 aufschraubbar ist. Mit der Außenblende 99 sind die Kühlmittelleitung 22 und die Befestigungsmittel 97 abgedeckt und somit einerseits vor Zugriff und andererseits vor unsachgemäßer Beschädigung geschützt. So verbirgt die Außenblende 99 die technischen Installationen vor direktem Blick und Zugriff und verleiht der Apparatur 100 ein attraktives Äußeres.

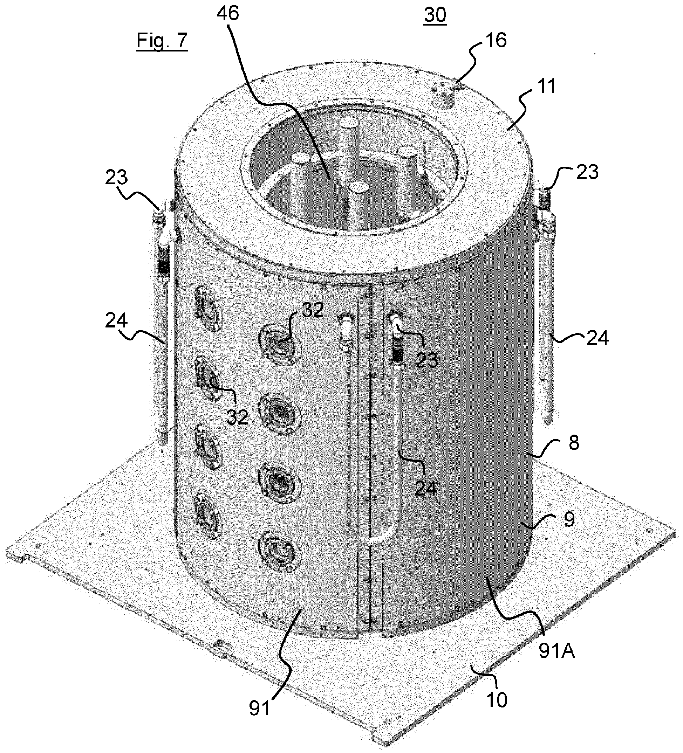

Fig. 7 zeigt schließlich eine auf dem Boden 10 aufgebaute Apparatur 100 mit mehrteiliger Behälterwandung 9, welche Wandungsabschnitte 91 und 91A umfasst. Die Kühlmittelleitungen 22 (vgl. z.B. Fig. 5 oder 6) verlaufen geschützt hinter der Außenblende 99 und sind mittels Ausgleichsbögen 24 miteinander kommunizierend verbunden, so dass ein Kühlmittel - z.B. Wasser - durch die Temperierungseinrichtung 21 fließen kann. Die Prozesskammer 4 (vgl. z.B. Fig. 1 oder 3) ist allseits von der Sicherheitsatmosphäre umgeben - oder je nach Ausführungsform jedenfalls oberhalb des Bodens 10 allseits von der Sicherheitsatmosphäre umgeben. Sollte die Prozesskammer 4 bersten oder anderweitig versagen und Prozessgas entweichen, so vermischt sich das Prozessgas mit dem im Innenraum 12 vorgehaltenen Schutzgas zu einem ungefährlichen Mischgas.

Es ist dem Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne den Schutzbereich der Ansprüche zu verlassen. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind. In allen Figuren stellen gleiche Bezugszeichen gleiche Gegenstände dar, so dass Beschreibungen von Gegenständen, die gegebenenfalls nur in einer oder jedenfalls nicht hinsichtlich aller Figuren erwähnt sind, auch auf diese Figuren und Ausführungsbeispiele übertragen werden können, hinsichtlich welchem der Gegenstand in der Beschreibung nicht explizit beschrieben ist.

### Bezugszeichenliste

- 1: Wachstumszelle
- 2: Quellmaterial
- 3: Keim
- 4: Prozesskammer
- 5: Einlassventil
- 6: Heizeinrichtung
- 7: Induktionsspule
- 8: Sicherheitsbehälter
- 9: Behälterwandung
- 10: Boden
- 11: Decke
- 12: Zwischenraum
- 13: Wechselventil
- 14: Argonquelle
- 15: Stickstoffquelle
- 16: Auslass(ventil)
- 17: Gassensor
- 18: Drucksensor
- 19: Steuereinrichtung
- 20: Haube
- 21: Kühl- bzw. Temperierungseinrichtung
- 22: Kühlmittelleitung
- 22A: Leitungsbefestigung
- 23: Anschlussstück
- 23A: Anschlusshalter
- 23B: Bogenstück
- 24: Ausgleichsbogen
- 30: Umgebung
- 32: Schauglas
- 41: Prozesskammerwand
- 44: Innenwand des Sicherheitsbehälters
- 46: Adapter
- 47: obere Abdeckung der Prozesskammer
- 48: obere Abdeckung der Prozesskammer
- 51: Prozessgaszuführung
- 52: Prozessgasabführung
- 54: Schutzgaszuführung
- 62: abgedichtete Durchführung
- 91: Abschnitt der Behälterwandung
- 91A: weiterer Abschnitt der Behälterwandung
- 92: Rahmenteil
- 94: Rahmenteil
- 96: Befestigungselement
- 97: Befestigungselement
- 98: Innenwand
- 99: Außenblende
- 100: Apparatur
- 122: Zwischenbereich

## Patentansprüche

1. PVT-Verfahren zum prozesssicheren Herstellen von Einkristallen in einer Apparatur, die eine hoch erhitzbare Wachstumszelle (1), eine Prozesskammer (4), in der sich die Wachstumszelle (1) befindet, und eine die Prozesskammer (4) umgebende Heizeinrichtung (6) zum Erhitzen der Wachstumszelle (1) aufweist, wobei ein Quellmaterial (2) und ein Keim (3) in die Wachstumszelle (1) eingebracht werden, die Prozesskammer (4) mit einem Prozessgas befüllt und die Wachstumszelle (1) erhitzt wird, so dass das Quellmaterial (2) sublimiert und am Keim (3) resublimiert wird, **dadurch gekennzeichnet, dass** das Prozessgas zum Teil oder vollständig aus einem reaktiven Gas besteht und dass die Prozesskammer (4) in einem Sicherheitsbehälter (8) angeordnet wird, wobei ein Zwischenraum (12) zwischen einer Behälterwandung (9) des Sicherheitsbehälters (8) und der Prozesskammer (4) mit einer Schutzatmosphäre geflutet wird, um die darin befindliche Luft zu verdrängen, bevor die Sublimation des Quellmaterials (2) eingeleitet wird.

2. PVT-Verfahren nach Anspruch 1, **dadurch gekennzeichnet, dass** das reaktive Gas Wasserstoff umfasst oder daraus besteht, und/oder dass die Schutzatmosphäre ein Inertgas umfasst oder daraus besteht.

3. PVT-Verfahren nach Anspruch 1 oder 2, **dadurch gekennzeichnet, dass** der Sicherheitsbehälter (8) so aufgebaut ist, dass er Gasverluste nach außen zulässt, und dass Inertgas nachgeführt wird, um Gasverluste auszugleichen und um einen Überdruck im Sicherheitsbehälter (8) aufrechtzuerhalten.

4. PVT-Verfahren nach Anspruch 3, **dadurch gekennzeichnet, dass** zum Fluten des Sicherheitsbehälters (8) ein erstes Inertgas, das schwerer als Luft ist, in seinen unteren Bereich eingelassen wird, wobei die Luft nach oben verdrängt wird, wozu ein verschließbarer Auslass am oberen Ende des Sicherheitsbehälters (8) so lange offen bleibt, bis die Luft entwichen ist.

5. PVT-Verfahren nach Anspruch 4, **dadurch gekennzeichnet, dass** es sich bei dem ersten Inertgas um Argon handelt.

6. PVT-Verfahren nach Anspruch 4 oder 5, **dadurch gekennzeichnet, dass** nach einem ein- oder mehrmaligen Fluten des Sicherheitsbehälters (8) mit dem ersten Inertgas, dieses durch ein zweites Inertgas, insbesondere Stickstoff, ersetzt wird.

7. PVT-Verfahren nach einem der vorhergehenden Ansprüche, **dadurch gekennzeichnet, dass** der Sicherheitsbehälter (8) einen Gassensor (17) aufweist, der in der Lage ist, das reaktive Gas zu detektieren, und dass die Prozessgaszufuhr zur Prozesskammer (4) unterbrochen wird, wenn der Gassensor (17) das reaktive Gas im Sicherheitsbehälter (8) detektiert.

8. Apparatur zum prozesssicheren Herstellen von Einkristallen nach dem PVT-Verfahren, die zur Aufnahme eines Quellmaterials (2) und eines Keims (3) eine hoch erhitzbare Wachstumszelle (1), eine Prozesskammer (4), in der sich die Wachstumszelle (1) befindet und die zu ihrer Befüllung mit einem Prozessgas einen Anschluss an eine Prozessgasquelle hat, und eine Heizeinrichtung (6) zum Erhitzen der Wachstumszelle (1) aufweist, **dadurch gekennzeichnet, dass** die Apparatur einen eine Behälterwandung (9) aufweisenden Sicherheitsbehälter (8) aufweist, in dem die Prozesskammer (4) angeordnet ist, und dass der Sicherheitsbehälter (8) einen Anschluss an eine Schutzgasquelle (14, 15) hat, um vor Durchführung des PVT-Verfahrens einen Zwischenraum (12) zwischen der Behälterwandung (9) des Sicherheitsbehälters (8) und der Prozesskammer (4) mit einer Schutzatmosphäre fluten zu können.

9. Apparatur nach Anspruch 8, **dadurch gekennzeichnet, dass** der Sicherheitsbehälter (8) so aufgebaut ist, dass er Gasverluste nach außen zulässt, dass er einen Drucksensor (18) aufweist und dass der Drucksensor (18) mit einer Steuereinrichtung (19) signalverbunden ist, wobei die Steuereinrichtung (19) so ausgelegt ist, dass auf Basis der Drucksensorsignale ein Überdruck im Sicherheitsbehälter (8) eingestellt wird.

10. Apparatur nach Anspruch 8 oder 9, **dadurch gekennzeichnet, dass** bezogen auf die intendierte Aufstellung der Apparatur ein Inertgasanschluss sich im unteren Bereich des Sicherheitsbehälters (8) und ein verschließbarer Auslass sich in dessen oberen Bereich befinden.

11. Apparatur nach einem der Ansprüche 8 bis 10, **dadurch gekennzeichnet, dass** der Sicherheitsbehälter zwei Inertgasanschlüsse für zwei unterschiedliche Inertgase aufweist.

12. Apparatur nach einem der Ansprüche 8 bis 11, **dadurch gekennzeichnet, dass** der Sicherheitsbehälter (8) einen Gassensor (17) aufweist, der auf ein reaktives Gas anspricht.

13. Apparatur nach einem der Ansprüche 8 bis 12, **dadurch gekennzeichnet,**
**dass** die Wachstumszelle (1) mit einem Siliciumcarbid als Quellmaterial (2) bestückbar ist, und
**dass** die Prozesskammer (4) mit Wasserstoff als reaktives Gas flutbar ist.

## Claims

1. PVT method for the process-safe production of single crystals in an apparatus which has a highly heatable growth cell (1), a process chamber (4) in which the growth cell (1) is located and a heating device (6) surrounding the process chamber (4) for heating the growth cell (1), wherein a swelling material (2) and a seed (3) being introduced into the growth cell (1), the process chamber (4) being filled with a process gas and the growth cell (1) being heated, so that the source material (2) is sublimated and resublimated at the seed (3), **characterised in that** the process gas consists partly or completely of a reactive gas and **in that** the process chamber (4) is arranged in a containment vessel (8), an intermediate chamber (12) between a container wall (9) of the containment vessel (8) and the process chamber (4) being flooded with a protective atmosphere in order to displace the air present therein before the sublimation of the source material (2) is initiated.

2. The PVT process according to claim 1, **characterised in that** the reactive gas comprises or consists of hydrogen, and/or **in that** the protective atmosphere comprises or consists of an inert gas.

3. PVT process according to claim 1 or 2, **characterised in that** the containment vessel (8) is constructed in such a way that it allows gas losses to the outside, and that inert gas is supplied to compensate for gas losses and to maintain an overpressure in the containment vessel (8).

4. PVT process according to claim 3, **characterised in that**, for flooding the containment vessel (8), a first inert gas which is heavier than air is admitted into its lower region, the air being displaced upwards, for which purpose a closable outlet at the upper end of the containment vessel (8) remains open until the air has escaped.

5. PVT process according to claim 4, **characterised in that** the first inert gas is argon.

6. PVT process according to claim 4 or 5, **characterised in that** after the containment vessel (8) has been flooded once or several times with the first inert gas, it is replaced by a second inert gas, for example nitrogen.

7. PVT process according to one of the preceding claims, **characterised in that** the containment vessel (8) has a gas sensor (17) which is capable of detecting the reactive gas, and **in that** the process gas supply to the process chamber (4) is interrupted when the gas sensor (17) detects the reactive gas in the containment vessel (8).

8. Apparatus for the process-safe production of single crystals by the PVT method, which apparatus has a highly heatable growth cell (1) for receiving a source material (2) and a seed (3), a process chamber (4) in which the growth cell (1) is located and which has a connection to a process gas source for filling it with a process gas, and a heating device (6) for heating the growth cell (1), **characterised in that** the apparatus has a containment vessel (8) which has a container wall (9) and in which the process chamber (4) is arranged, and **in that** the containment vessel (8) has a connection to a protective gas source (14, 15) in order to be able to flood an intermediate chamber (12) between the container wall (9) of the containment vessel (8) and the process chamber (4) with a protective atmosphere before the PVT process is carried out.

9. Apparatus according to claim 8, **characterised in that** the containment vessel (8) is constructed in such a way that it allows gas losses to the outside, that it has a pressure sensor (18) and that the pressure sensor (18) is signal-connected to a control device (19), the control device (19) being designed in such a way that an overpressure in the containment vessel (8) is set on the basis of the pressure sensor signals.

10. Apparatus according to claim 8 or 9, **characterised in that**, with respect to the intended installation of the apparatus, an inert gas connection is located in the lower region of the containment vessel (8) and a closable outlet is located in its upper region.

11. Apparatus according to one of claims 8 to 10, **characterised in that** the containment vessel has two inert gas connections for two different inert gases.

12. Apparatus according to any one of claims 8 to 11, **characterised in that** the containment vessel (8) comprises a gas sensor (17) which responds to a reactive gas.

13. Apparatus according to any one of claims 8 to 12, **characterised in that** the growth cell (1) is equipped with a silicon carbide as source material (2) and
the process chamber (4) is flooded with hydrogen as reactive gas.

## Revendications

1. Procédé PVT pour la fabrication sûre de monocristaux dans un appareil qui présente une cellule de croissance (1) pouvant être chauffée à haute température, une chambre de processus (4) dans laquelle se trouve la cellule de croissance (1), et un dispositif de chauffage (6) entourant la chambre de processus (4) pour chauffer la cellule de croissance (1), un matériau source (2) et un germe (3) étant introduits dans la cellule de croissance (1), la chambre de processus (4) étant remplie d'un gaz de processus et la cellule de croissance (1) étant chauffée, de sorte que le matériau source (2) est sublimé et est resublimé au niveau du germe (3), **caractérisé en ce que** le gaz de processus est constitué en partie ou entièrement d'un gaz réactif et **en ce que** la chambre de processus (4) est disposée dans un récipient de sécurité (8), un espace intermédiaire (12) entre une paroi de récipient (9) du récipient de sécurité (8) et la chambre de processus (4) étant inondé d'une atmosphère protectrice afin de refouler l'air qui s'y trouve avant que la sublimation du matériau source (2) ne soit initiée.

2. Procédé PVT selon la revendication 1, **caractérisé en ce que** le gaz réactif comprend ou est constitué d'hydrogène et/ou **en ce que** l'atmosphère protectrice comprend ou est constituée d'un gaz inerte.

3. Procédé PVT selon la revendication 1 ou 2, **caractérisé en ce que** le récipient de sécurité (8) est construite de manière à permettre des pertes de gaz vers l'extérieur, et **en ce que** du gaz inerte est ajouté pour compenser les pertes de gaz et pour maintenir une surpression dans le récipient de sécurité (8).

4. Procédé PVT selon la revendication 3, **caractérisé en ce que**, pour inonder le récipient de sécurité (8), un premier gaz inerte plus lourd que l'air est admis dans sa partie inférieure, l'air étant déplacé vers le haut, une sortie obturable étant laissée ouverte à l'extrémité supérieure de le récipient de sécurité (8) jusqu'à ce que l'air soit évacué.

5. Procédé PVT selon la revendication 4, **caractérisé en ce que** le premier gaz inerte est de l'argon.

6. Procédé PVT selon la revendication 4 ou 5, **caractérisé en ce qu'**après un ou plusieurs noyages de le récipient de sécurité (8) avec le premier gaz inerte, celui-ci est remplacé par un deuxième gaz inerte, en particulier de l'azote.

7. procédé PVT selon l'une des revendications précédentes, **caractérisé en ce que** le récipient de sécurité (8) comporte un capteur de gaz (17) apte à détecter le gaz réactif, et **en ce que** l'alimentation en gaz de traitement de la chambre de processus (4) est interrompue lorsque le capteur de gaz (17) détecte le gaz réactif dans le récipient de sécurité (8) .

8. Appareil pour la fabrication sûre de monocristaux selon le procédé PVT, qui présente, pour la réception d'un matériau source (2) et d'un germe (3), une cellule de croissance (1) pouvant être chauffée à haute température, une chambre de processus (4) dans laquelle se trouve la cellule de croissance (1) et qui a un raccordement à une source de gaz de processus pour son remplissage avec un gaz de processus, et un dispositif de chauffage (6) pour le chauffage de la cellule de croissance (1), **caractérisé, en ce que** l'appareil présente un récipient de sécurité (8) présentant une paroi de récipient (9), dans lequel est disposée la chambre de processus (4), et **en ce que** le récipient de sécurité (8) a un raccordement à une source de gaz protecteur (14, 15), afin de pouvoir inonder d'une atmosphère protectrice un espace intermédiaire (12) entre la paroi de récipient (9) du récipient de sécurité (8) et la chambre de processus (4) avant la mise en oeuvre du procédé PVT.

9. Appareil selon la revendication 8, **caractérisé en ce que** le récipient de sécurité (8) est construite de manière à permettre des pertes de gaz vers l'extérieur, **en ce qu'**elle présente un capteur de pression (18) et **en ce que** le capteur de pression (18) est relié par signaux à un dispositif de commande (19), le dispositif de commande (19) étant conçu de telle sorte qu'une surpression dans le récipient de sécurité (8) est réglée sur la base des signaux du capteur de pression.

10. Appareil selon la revendication 8 ou 9, **caractérisé en ce que**, par rapport à l'installation prévue de l'appareil, un raccord de gaz inerte se trouve dans la zone inférieure du récipient de sécurité (8) et une sortie obturable se trouve dans sa zone supérieure.

11. Appareil selon l'une des revendications 8 à 10, **caractérisé en ce que** l'enceinte de confinement comporte deux raccords de gaz inerte pour deux gaz inertes différents.

12. Appareil selon l'une des revendications 8 à 11, **caractérisé en ce que** le récipient de sécurité (8) comporte un capteur de gaz (17) sensible à un gaz réactif.

13. Appareil selon l'une des revendications 8 à 12, **caractérisé**
**en ce que** la cellule de croissance (1) peut être équipée d'un carbure de silicium comme matériau source (2), et
**en ce que** la chambre de processus (4) peut être inondée d'hydrogène comme gaz réactif.
